(19) Europäisches Patentamt
European Patent Office
Office européen des brevets

(11) **EP 0 614 278 B1**

(12) **EUROPEAN PATENT SPECIFICATION**

(45) Date of publication and mention
of the grant of the patent:
**28.01.1998 Bulletin 1998/05**

(51) Int Cl.$^6$: **H03K 17/08**, H03K 17/56

(21) Application number: **94100600.9**

(22) Date of filing: **16.11.1989**

(54) **Drive circuit for use with voltage-driven semiconductor device**

Treiberschaltung für eine spannungsgesteuerte Halbleitervorrichtung

Circuit d'attaque pour dispositif semi-conducteur commandé par tension

(84) Designated Contracting States:
**DE ES FR GB**

(30) Priority: 16.11.1988 JP 289231/88
22.12.1988 JP 324359/88
20.03.1989 JP 68821/89
12.07.1989 JP 179497/89
14.07.1989 JP 181771/89
29.08.1989 JP 222642/89
20.04.1989 JP 100569/89

(43) Date of publication of application:
**07.09.1994 Bulletin 1994/36**

(62) Document number(s) of the earlier application(s) in
accordance with Art. 76 EPC:
**89121235.9 / 0 369 448**

(73) Proprietor: **FUJI ELECTRIC CO., LTD.**
**Kawasaki-shi Kanagawa 210 (JP)**

(72) Inventors:
• Sasagwa, Kiyoaki, c/o Fuji Electric Co., Ltd.
Kawasaki-shi, Kanagawa (JP)
• Miki, Hiroshi, c/o Fuji Electric Co., Ltd.
Kawasaki-shi, Kanagawa (JP)
• Miyasaka, Tadashi, c/o Fuji Electric Co., Ltd.
Kawasaki-shi, Kanagawa (JP)
• Ninomiya, Hideki, c/o Fuji Electric Co., Ltd.
Kawasaki-shi, Kanagawa (JP)

(74) Representative: **Grünecker, Kinkeldey,**
**Stockmair & Schwanhäusser Anwaltssozietät**
**Maximilianstrasse 58**
**80538 München (DE)**

(56) References cited:
**EP-A- 0 190 925** **EP-A- 0 206 505**

## Description

The present invention relates to a drive circuit for use with voltage-driven semiconductor devices such as IGBTs (insultated-gate bipolar transistors) and power MOS FETs. The present invention also relates to a common output circuit for driving dissimilar switching semiconductor devices (power devices) having different drive input characteristics that are respectively composed of the IGBTs and the MOS FETs.

Power devices are usually driven with different circuits having configuration adapted for the drive input characterestics inherent in the individual devices.

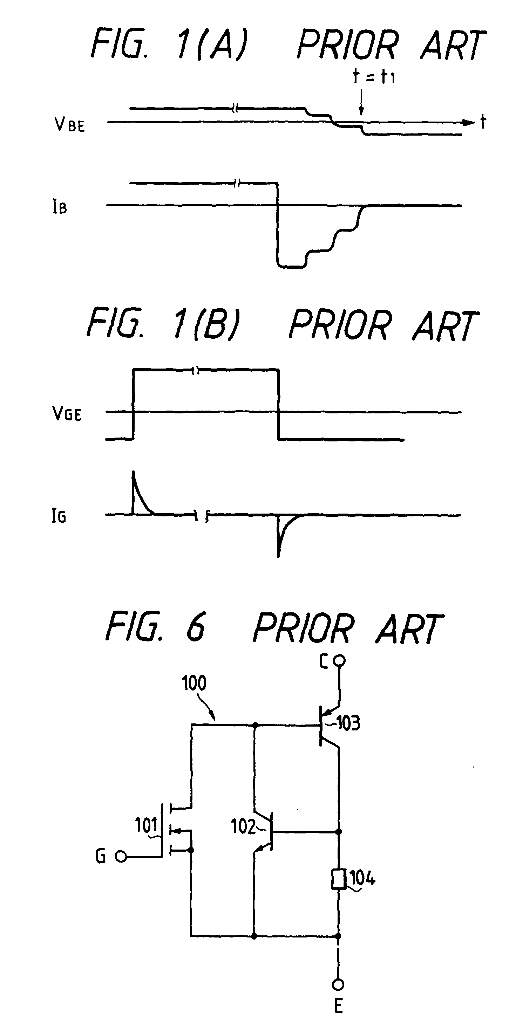

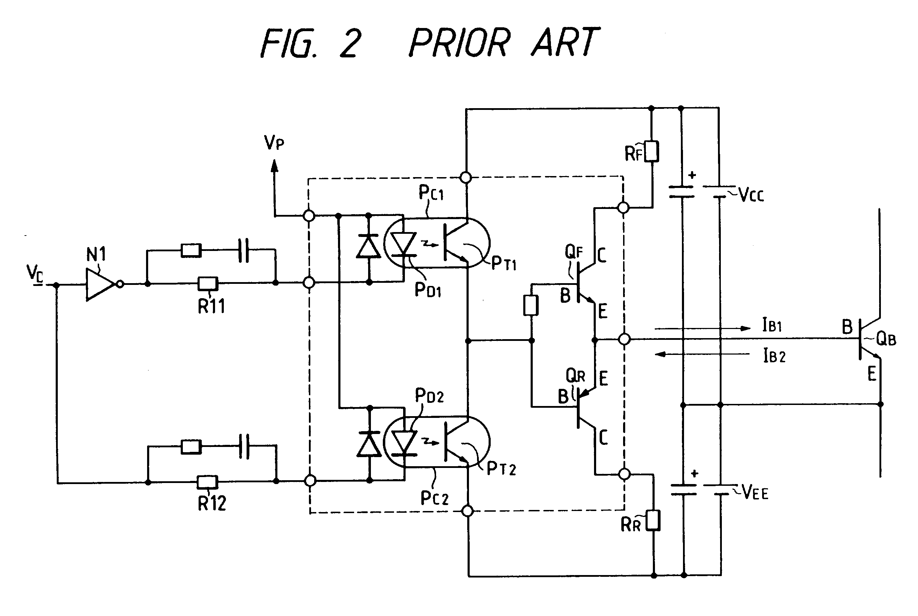

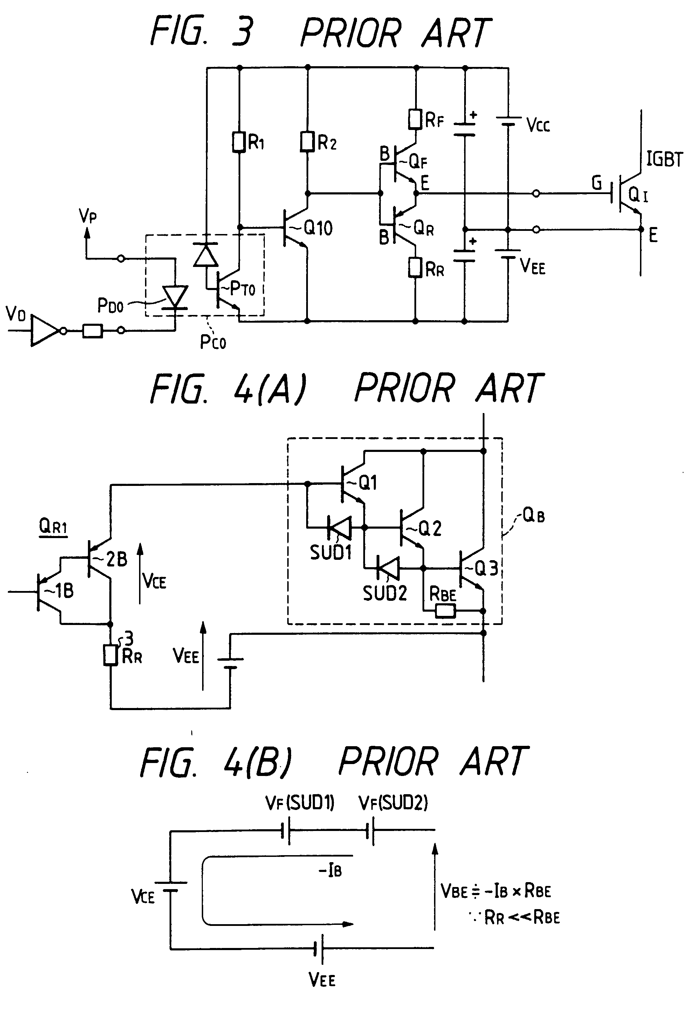

Figs. 1(A) and 1(B) illustrate the drive input characteristics of two dissimilar power devices; Fig. 1(A) shows illustrative waveforms of the base-emitter voltage VBE of a bipolar transistor and the corresponding base current IB, and Fig. 1(B) shows illustrative waveforms of the gate-emitter voltage VGE of an IGBT and the corresponding gate current IG. Fig. 2 shows a circuit for driving the bipolar transistor and Fig. 3 shows a circuit for driving the IGBT.

The circuit shown in Fig. 2 includes a bipolar transistor QB as the power device to be driven, a forward drive dc power supply VCC, a reverse drive dc power supply VEE, a forward drive output stage transistor QF, and a reverse drive output stage transistor QR.

When a "High" ("H") drive signal VD is supplied, it is inverted by a NOT gate N1 and turns one photocoupler PC1 on while turning the other photocoupler PC2 off. As a result, a base current is supplied to the forward drive output stage transistor QF through the path consisting of dc power supply VCC, phototransistor PD1 in photocoupler PC1, the base-emitter of output stage transistor QF, the base-emitter of bipolar transistor QB and dc power supply VCC, and output stage transistor QF is thus turned on whereas the other output stage transistor QR for reverse drive is turned off. Hence, a base current IB1 as a forward drive current is supplied to bipolar transistor QB through the path consisting of dc power supply VCC, forward base current limiting resistor RF, the collector-emitter of output stage transistor QF, the base-emitter of bipolar transistor QB, and dc power supply VCC, and the bipolar transistor QB is thus turned on.

If the drive signal VD is at a "Low" ("L") level, photocoupler PC1 turns off and photocoupler PC2 turns on. As a result, the forward output stage transistor QF is turned off and a base current is supplied to the reverse drive output stage transistor QR through the path consisting of dc power supply VEE, the emitter-base of bipolar transistor QB, the emitter-base of output stage transistor QR, phototransistor PT2 in photocoupler PC2, and dc power supply VEE, and the output stage transistor QR turns on. Hence, a base current IB2 as a reverse drive current is supplied to bipolar transistor QB through the path consisting of dc power supply VEE, the emitter-base of bipolar transistor QB, the emitter-collector of output stage transistor QR, reverse base current limiting resistor RR, and dc power supply VEE, and the bipolar transistor QB is thus turned off.

In the circuit shown in Fig. 3, when a "H" drive signal VD is supplied, photocoupler PCO turns on whereas auxiliary transistor Q10 turns off. As a result, reverse output stage transistor QR turns off and a base current is supplied to forward output stage transistor QF through the path consisting of dc power supply VCC, resistor R2, the base-emitter of output stage transistor QF, the gate-emitter of IGBT QI, and dc power supply VCC, thereby causing the forward output stage transistor QF to turn on. Hence, a forward drive voltage from dc power supply VCC is applied between the gate and emitter of IGBT QI through resistor RF to turn IGBT QI on.

If the drive signal VD is at a "L" level, photocoupler PCO turns off whereas auxiliary transistor Q10 turns on. As a result, forward output stage transistor QF turns off and a base current is supplied to reverse output stage transistor QR through the path consisting of dc power supply VEE, the emitter-gate of IGBT QI, the emitter-base of output stage transistor QR, auxiliary transistor Q10, and dc power supply VEE, and the reverse output stage transistor QR turns on. Hence, a reverse drive voltage from dc power supply VEE is applied between the gate and emitter of IGBT QI through resistor RR to turn IGBT QI off.

Turning back to Fig. 1, a bipolar transistor is a current-driven device as shown in Fig. 1(A) and in order to keep it in conduction, a base current must be kept supplied in an amount sufficient to compensate for the collector current. When turning off the conducting device, the base is supplied with a reverse bias current larger than the forward bias base current in order to shorten the time required for turning the device off. The forward bias base current could theoretically be reduced by connecting a plurality of bipolar transistors QB in Darlington configuration as shown in Fig. 4 (where three bipolar transistors are connected). In practice, however, this is difficult to achieve since the value of reverse bias base current must comply with the ratings of bipolar transistor Q3 at the final stage of the Darlington connection (See Fig. 4). Thus, the base current of bipolar transistors will typically assume the wave form indicated by IB in Fig. 1(A) (if they are connected in a three-stage Darlington configuration). Subsequent to t = $t_1$, transistor Q3 at the final stage of the Darlington connection (Fig. 4) will restore the base-emitter junction and the reverse bias base current will flow through resistor RBE (Fig. 4) connected in parallel between the base and emitter of Q3. The value of this base current is extremely small (e.g. 50 mA). In order to insure that the transistors remain off throughout the period subsequent to $t_1$, a reverse bias voltage of approximately one volt is desirably applied between the base and emitter of final stage transistor Q3.

In contrast with the bipolar transistor, IGBT is a voltage-driven device as shown in Fig. 1(B) and in order to turn it on with an adequately low voltage, it is effective to increase the gate voltage as much as possible within the permissible range. In order to turn the IGBT off, a negative voltage is applied between the gate and emitter and the charge in the input capacitance is removed. Hence, the drive voltage of IGBT will typically assume the waveform indicated by VGE in Fig. 1(B). Since the gate of IGBT seen from the drive circuit is equivalent to a capacitive load, the gate current IG is produced by charging and discharging cycles of the input capacitance through a gate series resistor as shown in Fig. 1(B). The absolute values of the positive and negative peaks of gate current IG are equal and the duration of its passage, which may be considered in terms of the time constant determined by the value of gate series resistor and the input capacitance, is as short as 1 μsec or below. Therefore, if the IGBT is to be used at switching frequencies below 20 kHz, the heat generation of output stage transistors QF and QR in the drive circuit can safely be neglected for practical purposes.

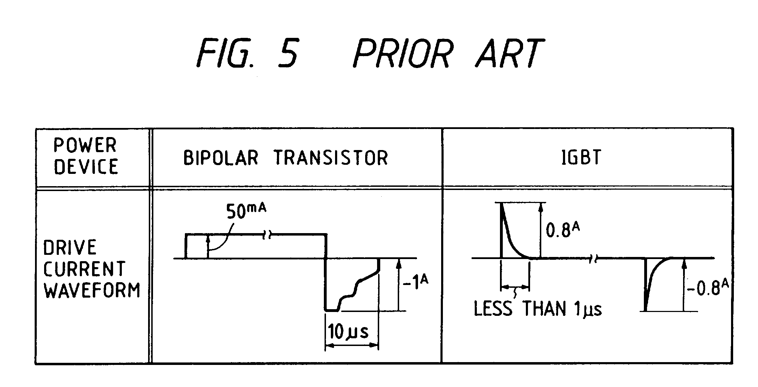

As is clear from Figs. 2 and 3, the basic compositions of output stage transistors QF and QR in the drive circuit are not much different between the driven power device QB (bipolar transistor) and QI (IGBT), except for the configuration of the output stage transistors QF and QR (whether they are connected in Darlington configuration or used singly) and the amount of resulting power loss. Compare, for example, the case of driving a bipolar transistor QB of 50 A class (composed of three transistors in Darlington configuration) with the case of driving IGBT QI. Typical waveforms of currents used to drive QB and QI are shown in Fig. 5. If a common output circuit is to be used to drive both types of device, a maximum collector current of forward drive current supply transistor (QF in Figs. 2 and 3) is determined by the condition for driving IGBT (0.8 A in the case being considered), and the power loss that will occur in this supply transistor QF is determined by the output current for driving bipolar transistor QB (50 mA in the case being considered) and the saturation voltage of transistor QF in that output stage. On the other hand, a maximum collector current of the transistor for withdrawing the reverse current from the power device being driven (QR in Figs. 2 and 3) is determined by the maximum value of the reverse bias current of the bipolar transistor (-1 A in the case being considered), and the power loss that will occur in this withdrawing transistor QR is determined by the reverse bias (base) current containing the current flowing through resistor RBE connected in parallel between the base and emitter of Q3 (see Fig. 4) during reverse biasing of bipolar transistor QB and by the saturation voltage of the withdrawing transistor for the case where said small current is allowed to flow as its own collector current.

It should be noted here that the saturation voltage of withdrawing transistor QR which occurs when it is supplied with a small collector current is restricted by the voltage value of dc power source VEE for supplying a reverse bias current to the bipolar transistor. This reverse bias voltage is illustrated in Fig. 4. Fig. 4(A) is a connection diagram for the case where bipolar transistor QB as a power device that consists of three transistors connected in Darlington configuration is reverse biased with reverse current withdrawing transistor QR1 as a reverse drive transistor that consists of two transistors connected in Darlington configuration, and Fig. 4(B) is the equivalent circuit of Fig. 4(A).

In order that a reverse voltage VBE of about one volt is applied between the base and emitter of transistor Q3 at the final stage of bipolar transistor QB in the Darlington connection after it has restored the base-emitter junction, the following relationship must be satisfied:

$$VBE = VCE + VF(SUD1) + VF(SUD2) - VEE$$

$$\equiv -1(V) \tag{1}$$

where VCE is the collector-emitter voltage of transistor 2B at the output stage of withdrawing transistor QR1; VF(SUD1) is the forward voltage drop in diode SUD1 connected anti-parallel between the base and emitter of transistor Q1 in bipolar transistor QB; and VF(SUD2) is the forward voltage drop in diode SUD2 connected antiparallel between the base and emitter of transistor Q2 in bipolar transistor QB. As one can see from equation (1), the higher the saturation voltage VCE of the withdrawing transistor QR1 in the drive circuit, the higher the value of VEE that is necessary. In addition, the higher the saturation voltage VCE, the greater the power loss that should occur in this mode.

As already mentioned, power devices are usually driven with different circuits depending upon the input characteristics of the specific device to be driven. The present invention intends to design a single common drive circuit for the purpose of realizing an IC package that is capable of driving and controlling various types of power devices. The drive circuits for power devices should handle fairly large currents, so one of the problems that have to be dealt with in putting the drive circuits inside a single IC package is the power loss that occurs in the package. As already mentioned, in order to make a single drive circuit that can be used with both a bipolar transistor and an IGBT, the circuit performance must satisfy the following conditions: transistors at the output stage of the drive circuit can be supplied with a current having a high peak value within a short period of time, with the same base current flowing; and a small current can be supplied for a prolonged period without generating much heat. In other words, the transistors at the output stage must have a low saturation voltage within the range of small drive output currents. In order to satisfy the first condition, the drive transistors at the output stage must be connected in Darlington configuration but the Darlington connection has an increased overall saturation voltage, which leads to greater power loss.

Next, conventional drive circuits for voltage-driven semiconductor devices such as IGBT will be described.

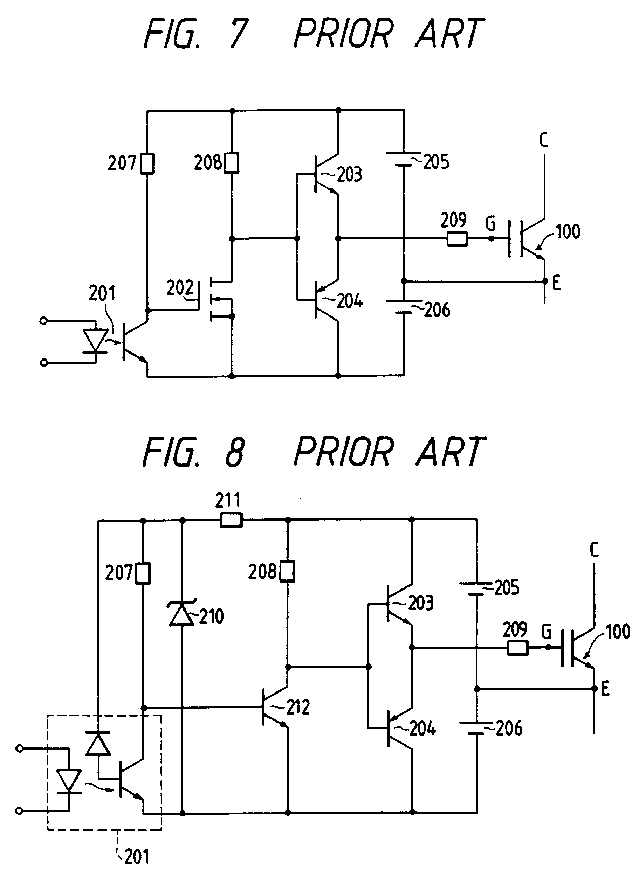

An equivalent circuit of such IGBT is shown in Fig. 6 and comprises an N channel MOS FET 101, an NPN transistor 102, a PNP transistor 103, and a resistor 104 for shorting the base and emitter of transistor 102. These components combine together to make an IGBT 100 having a gate G, a collector C and an emitter E. Transistors 102 and 103 also make up a parasitic thyristor circuit.

Fig. 7 shows a conventional circuit for driving IGBT 100 which comprises a signal insulating photocoupler 201 connected to a control circuit such as a PWM circuit (not shown), an N channel MOS FET 202, an NPN transistor 203, a PNP transistor 204, a forward bias supply source 205, a reverse bias supply source 206, and resistors 207, 208 and 209.

Using this drive circuit, IGBT 100 is turned on by the following procedure. When photocoupler 201 is energized on its primary side, it turns on, causing FET 202 to turn off. As FET 202 turns off, transistor 204 turns off, causing transistor 203 to turn on. When transistor 203 turns on, forward bias supply source 205 applies a voltage between the gate and emitter of IGBT 100 via resistor 209, thereby turning IGBT 100 on.

IGBT 100 is turned off by reversing the operation described above. When the current flowing to the primary side of photocoupler 201 is cut off, it turns off, causing FET 202 to turn on. As a result, transistor 203 turns off and transistor 204 turns on, whereupon reverse bias supply source 206 applies a voltage between the gate and emitter of IGBT 100 via resistor 9, thereby turning IGBT 100 off. Besides limiting the gate current of IGBT 100, resistor 209 ensures that the internal parasitic thyristor will not turn on (a phenomenon called "latch-up") when IGBT 100 is turned off, to have the gate lose its control ability for cutting off the current.

Fig. 8 shows another circuit for driving IGBT 100. This circuit includes a constant-voltage diode 210, a resistor 211 and an NPN transistor 212, with the other components being the same as shown in Fig. 7. The drive circuit shown in Fig. 8 operates in substantially the same way as the circuit shown in Fig. 7, and transistor 212 serves the same function as FET 202 in Fig. 7.

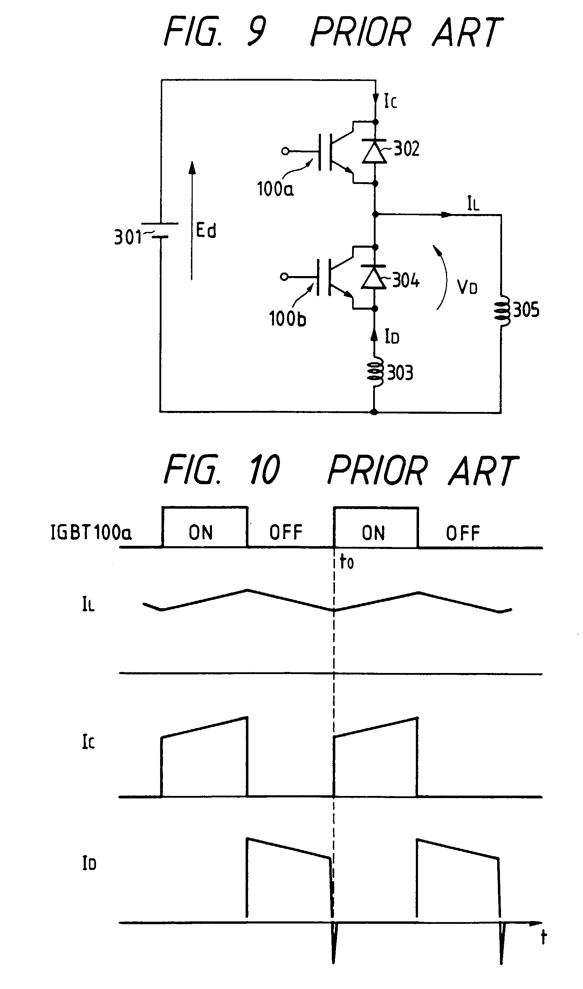

IGBTs of the type described above are chiefly used as a switch for turning on and off the current flowing to an inductive load such as a VVVF (variable voltage, variable frequency) inverter. The basic operation of the IGBT used as a switch is essentially the same as the operation of a chopper in the inverter circuit shown in Fig. 9 which comprises IGBTs 100a and 100b, a dc power source 301 (voltage, Ed), free-wheeling diodes 302 and 304, a wiring inductance 303, and a load 305, with a snubber circuit being omitted.

When IGBT 100a in the upper arm shown in Fig. 9 turns off as a result of the operation of the drive circuit in the manner described above, load current $I_L$ continues to flow through free-wheeling diode 304 in the lower arm. When IGBT 100a turns on with $I_L$ kept flowing through 304, a short circuit composed of dc power source 301, IGBT 100a and free-wheeling diode 304 is formed to create a dc short-circuited state until free-wheeling diode 304 turns off. Thus, high-speed diodes are normally used as free-wheeling diodes 304 and 302.

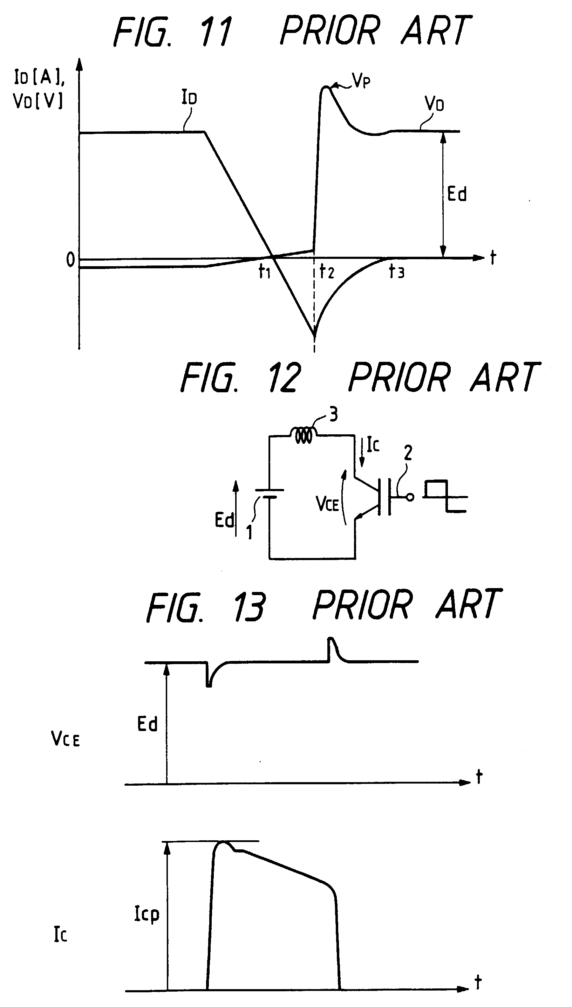

When IGBT 100a turns on, its collector current Ic and the load current $I_L$ will increase gradually as shown in Fig. 10. Considering a very short duration of time including $t_0$ when IGBT 100a turns on, current $I_D$ flowing through free-wheeling diode 304 decreases abruptly just before $t_0$ and thereafter increases again abruptly as shown in Fig. 10. The profiles of current $I_D$ and the voltage $V_D$ that develops across the free-wheeling diode 304 are shown more clearly in Fig. 11. The decreasing $I_D$ becomes zero at time $t_1$, thereafter increases in negative direction until it peaks at time $t_2$ (corresponding to $t_0$ in Fig. 10) and then becomes zero again at time $t_3$. The period from $t_1$ through $t_2$ to $t_3$ is commonly referred to as a "reverse recovery time". This reverse recovery time is very short and is usually within a microsecond.

With prior art semiconductor devices which have a longer switching time than the reverse recovery time, the abrupt changes of voltage and current that occur within the reverse recovery time have been suppressed by the switching time. However, the switching time of voltage-driven semiconductor devices such as IGBT are approximately equal to the reverse recovery time of diodes, so that the changes of voltage and current that occur within the reverse recovery time will not be suppressed but will simply increase further on.

In the period of $t_2$ to $t_3$, the reverse current (reverse recovery current) will decrease so abruptly that the rate of change of current (dI/dt) will increase. The faster the operation of diodes, the shorter the period of $t_2$ to $t_3$ and hence the greater the value of dI/dt. As a result, a voltage of the same polarity as that of the dc supply voltage Ed, $\Delta V = \ell s \cdot dI/dt$ ($\ell s$ is the inductance value of wiring inductance 303), which is generated by dI/dt and wiring inductance 303 is superposed on Ed, and voltage $V_D$ across the free-wheeling diode 304 will become very high as indicated by $V_P$ in Fig. 11. The value of $V_D$ may sometimes exceed the withstand voltage of the device of interest and IGBT 100b connected parallel to free-wheeling diode 304 can break or erroneously turn on.

Subsequent to time $t_2$, voltage $V_D$ will increase abruptly in a very short time and hence the rate of change of voltage (dV/dt) will also become very high, for example, more than $10 \times 10^3$ V/μs, causing erroneous operation of the photocoupler 201 in the drive circuit shown in Figs. 7 and 8 or of the control circuit on the input side of said photocoupler. If, in order to cope with this problem, one uses a photocoupler that is less sensitive to the change in voltage (dV/dt) and which is capable of high-speed signal transmission the drive circuit for IGBT becomes expensive, leading to an increase in the production cost.

Next, a conventional drive circuit having a capability for protecting voltage-driven semiconductor devices from overcurrent that may flow when ground fault and other shorting accidents occur in power converting apparatus such as an inverter, will be described.

While various overcurrent faults occur accidentally during the operation of power converting apparatus such as an inverter, shorting of loads and ground fault can lead to the destruction of voltage-driven semiconductor devices used in the apparatus. With IGBT taken as an example of voltage-driven semiconductor devices, Fig. 12 shows an equivalent circuit for a shorting accident that occurs in a power converting apparatus and Fig. 13 shows the voltage and current waveforms generated from the voltage-driven semiconductor device used in that apparatus.

During the shorting period, a short-circuit current will flow with a substantially dc circuit voltage being applied to IGBT 2 (see Fig. 12). The other components of the circuit shown in Fig. 12 are a dc power source 1 and wiring inductance 3.

The short-circuit current can be as large as 5 to 6 times (or even 10 times in high-voltage withstanding devices) the rated dc current. Thus, an extremely large instantaneous power will be applied to the device during the accident and it is necessary to cut off the overcurrent by turning off the gate within a prescribed time (about 10 µs) after the short-circuit has been sensed.

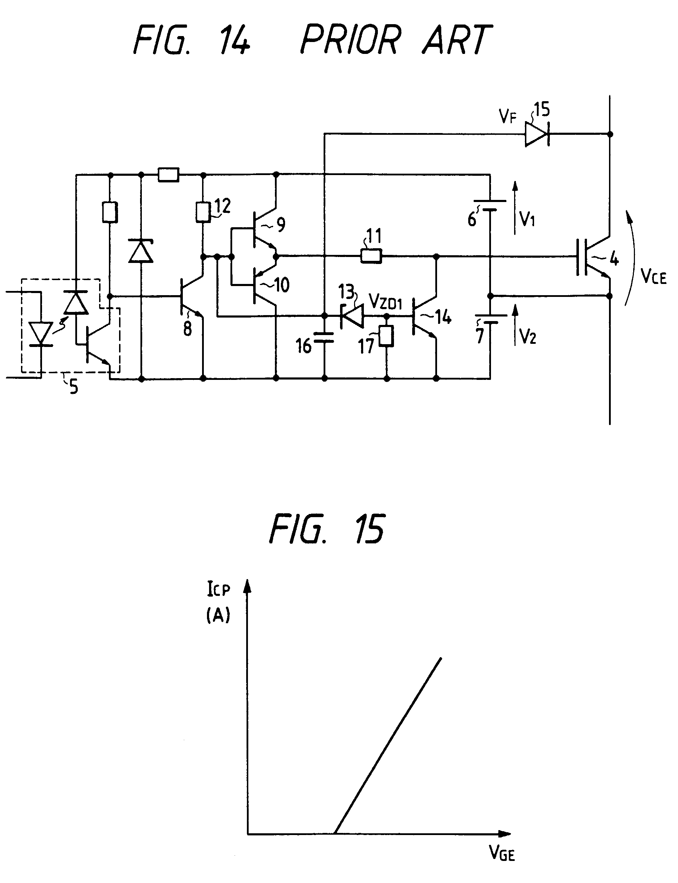

A prior art drive circuit having a capability for protecting voltage-driven semiconductor devices from overcurrent is shown in Fig. 14. The circuit includes an IGBT 4 as a main switching element, a signal insulating photocoupler 5, an ON gate voltage supply source 6, and an OFF gate voltage supply source 7. The two voltage sources 6 and 7 are connected to a pair of transistors 9 and 10 that operate in a complementary manner with photocoupler 5 in response to a signal supplied therefrom via transistor 8. The emitters of these transistors 9 and 10 at the output stage are connected to the base of IGBT 4 via resistor 11, and the junction between voltage sources 6 and 7 is connected to the emitter of IGBT 4 to make a drive section.

Transistor 14, zener diode 13, diode 15 and resistor 17 make up an overcurrent sensing section that monitors the voltage at the collector terminal of IGBT 4 and which produces a certain signal if said voltage exceeds a predetermined level.

A delay circuit is formed of a capacitor 16 upstream of the overcurrent sensing section.

The normal operation of the circuit shown in Fig. 14 will proceed as follows. When photocoupler 5 turns on, transistor 8 turns off, as a result of which transistor 9 turns on whereas transistor 10 turns off to apply ON gate voltage $V_1$ between the gate and emitter of IGBT 4 via resistor 11.

Since transistor 8 is off, a base current will flow to transistor 14 via resistor 12 and zener diode 13 but timing of its activation is delayed by the presence of resistor 17. When an ON gate voltage is applied between the gate and emitter of IGBT 4, the latter turns on and its collector-emitter voltage will drop to the level of ON voltage [hereinafter abbreviated as $V_{CE(ON)}$]. Thus, by selecting parts that satisfy the conditions set forth below, transistor 14 can be kept off while IGBT 4 is on:

$$V_{ZDI} + V_{BE} > V_2 + V_{CE(ON)} + V_F$$

where

$V_{ZD1}$ :    the threshold value of zener diode 13;
$V_{BE}$ :    the base-emitter voltage of transistor 14; and
$V_F$ :    the forward voltage of diode 15.

When photocoupler 5 turns off, transistor 8 turns on, as a result of which transistor 9 turns off and transistor 10 turns on to apply an OFF gate voltage between the gate and emitter of IGBT 4 via resistor 11, thereby turning IGBT 4 off. When transistor 8 turns on, capacitor 16 discharges so that IGBT 4 can be effectively turned on in a subsequent step.

If a shorting accident occurs when IGBT 4 is on its collector-emitter voltage increases until the following relationship is established:

$$V_{ZDI} + V_{BE} > V_2 + V_{CE(ON)} + V_F$$

As a result, transistor 14 conducts and an OFF gate voltage is applied between the gate and emitter of IGBT 4, thereby turning it off to cut off the flowing overcurrent.

When the prior art drive circuit shown in Fig. 14 operates to protect the voltage-driven semiconductor device of interest from overcurrent, an OFF gate voltage is applied to the gate of IGBT 4 simultaneously with conduction of transistor 14 and hence, a great decrease in current (-di/dt) will occur when the overcurrent is cut off. This involves the potential hazard of an excessive voltage [i.e., the sum of the voltage induced in the wiring inductance ($\ell s \cdot di/dt$) and the dc circuit voltage] of being exerted on IGBT 4.

Further, the delay circuit composed of capacitor 16 causes time lag in the sensing of overcurrent and an unduly great amount of energy will be consumed by the device in the period from the occurrence of shorting to the interruption of the overcurrent.

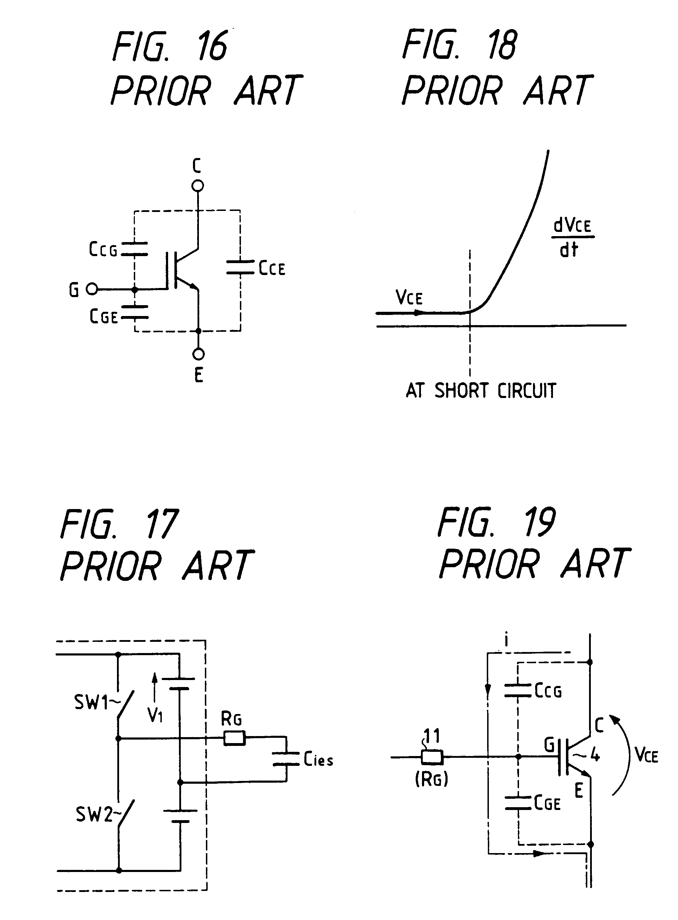

A further problem rises with IGBT 4 which has static capacitance between collector C, emitter E and gate G as shown in Fig. 16.

As shown by equivalent circuit in Fig. 17, input capacitance Cies charges and discharges in the switching process. Further, the characteristics of the semiconductor device, when it is in an ON state, depends on the value of voltage with which the input capacitance is charged, so that charging with a predetermined value of voltage is necessary in order to maintain constant device characteristics.

As described above, the load in the gate drive circuit is capacitive and this causes the possibility that the output voltage will not reach a predetermined value of gate voltage on account of the inherent characteristics of transistors 9 and 10 at the output stage. If the gate voltage is low, the ON voltage of IGBT 4 will increase and may potentially cause an increased power loss.

Further, the pulse currents rated for transistors are not very large and are only about twice the dc current rating. Hence, the capacity class of IGBT that can be driven is limited by the ratings of transistors at the output stage. A transistor that is capable of driving all classes of IGBT is bulky and will inevitably increase the size of the drive circuit.

If a shorting accident occurs when IGBT 4 is conducting, the flowing current will increase and at the same time, the device voltage ($V_{CE}$) will also increase markedly, producing a very large change in voltage $dV_{CE}/dt$ as shown in Fig. 18. As Fig. 19 shows, IGBT 4 has a junction capacitance $C_{CG}$ between collector (C) and gate (G) and when $dV_{CE}/dt$ is applied to IGBT 4, $C_{CG}$ produces a displacement current $i$ (= $C_{CG} \cdot dV_{CG}/dt$). This resulting displacement current will flow between the gate and emitter of IGBT 4 as shown in Fig. 19.

In the operation of the prior art drive circuit intended to protect the semiconductor circuit of interest form overcurrent, the charge between the gate and emitter of IGBT 4 is removed via resistor 11 (gate resistance) and transistor 10. Since resistor 11 increases the impedance of the drive circuit seen from the IGBT 4, the displacement current $i$ will not flow into transistor 10 from resistor 11 but rather flow directly into the space between the gate and emitter of IGBT 4.

This charging operation will prevent the gate-emitter voltage of IGBT 4 from charging in synchronism with the voltage developing upstream of resistor 11 (i.e., the voltage on the drive circuit side). As a consequence, there will be no decrease in voltage and the short-circuit current will no longer decrease. If the displacement current disappears in this situation, the gate-emitter voltage of IGBT 4 will decrease markedly, causing an abrupt decrease in the short-circuit current and hence a corresponding increase in the rate of its change (di/dt). If this occurs, it becomes impossible to suppress the voltage ($\ell s \cdot di/dt$) induced in the wiring inductance in the main circuit and an excessive voltage greater than what can be withstood by the device will develop and may potentially destroy the device. Further, the non-decreasing short-circuit current will cause the problem of increased energy consumption by the device. These problems become more pronounced as the capacitance (voltage and current ratings) of the device increases because $C_{CG}$ and hence the displacement current will increase.

Another problem with IGBT 4 is that it takes less than a few microseconds for the device to be turned off from the state where a large current is flowing. This causes an extremely large change of current (di/dt) when the device turns off and in the presence of wiring inductance (L), a higher voltage than can be withstood by the device might be applied between the collector and emitter of IGBT 4 (or between the drain and source of MOS FET).

SUMMARY OF THE INVENTION

The present invention was made to overcome the above described disadvantages of prior art drive circuits.

According to the present invention, a gate drive circuit having a voltage-driven semiconductor device and further comprising a free-wheeling diode connected in series with and in opposite direction to the output side of said voltage driven semiconductor device further includes a constant voltage circuit that supplies the gate of the semiconductor device with a voltage that is higher than the threshold voltage of the semiconductor device but which is lower than the voltage applied in a steady state, and a timer that causes the constant voltage circuit to operate, when the semiconductor device is on, for at least the reverse recovery time of the diode.

According to the present invention, when the voltage-driven semiconductor device is to be turned on, a relatively low constant voltage is applied between the gate and emitter of the semiconductor device by the constant voltage circuit for a certain period of time that is determined by the timer (i.e., a time longer than the reverse recovery time of the free-wheeling diode connected to the semiconductor device on the output side). As a result, the output current from the semiconductor device is suppressed to a small value and the rate of change of the reverse recovery current flowing through the diode connected in series at the output side becomes small enough to prevent the development of an overvoltage across the diode and the resulting change in voltage is so small that there will be no possibility of the semiconductor device turning on erroneously or being destroyed or of the drive circuit operating erroneously.

After the lapse of the certain period of time determined by the timer, the application of low voltage to the gate of the semiconductor device by means of the constant voltage circuit stops and a normal value of voltage will develop between the gate and emitter of the device, thus permitting an adequately large output current to be produced from the semiconductor device. Since the diode has already restored its reverse-blocking capability, no deleterious current will flow into this diode.

BRIEF DESCRIPTION OF THE DRAWINGS

Fig. 1(A) and 1(B) show timing charts for illustrative drive input characteristics of a bipolar transistor and an IGBT;
Fig. 2 is a diagram showing an illustrative composition of a circuit for driving a bipolar transistor;
Fig. 3 is a diagram showing an illustrative composition of a circuit for driving an IGBT;
Figs. 4(A) and 4(B) are an illustration of the reverse bias voltage of a bipolar transistor;
Fig. 5 shows timing charts for drive currents applied to power devices;
Fig. 6 is a diagram showing an equivalent circuit of IGBT;
Fig. 7 is a diagram showing an exemplary gate drive circuit;
Fig. 8 is a diagram showing another exemplary gate drive circuit;
Fig. 9 is a circuit diagram of a chopper using an IGBT;
Fig. 10 is a timing chart showing the waveforms generated from various operating components of the circuit shown in Fig. 9;
Fig. 11 is a diagram showing in the current and voltage waveforms generated fom a diode in the circuit shown in Fig. 9;
Fig. 12 is an equivalent circuit diagram for a shorting accident that occurs in a power converting apparatus using a voltage-driven semiconductor device;
Fig. 13 is a timing chart showing the voltage and current waveforms generated from the semiconductor device;
Fig. 14 is a circuit diagram showing a prior art drive circuits;
Fig. 15 is a graph showing a short-circuit current vs. the gate-emitter voltage of the semiconductor device;
Fig. 16 is a capacitive equivalent circuit diagram of IGBT;
Fig. 17 is an equivalent circuit diagram for the switching process;
Fig. 18 is a graph showing the voltage waveform generated when shorting occurs;
Fig. 19 is a diagram showing the state of a shorted semiconductor device;
Fig. 20 is a circuit diagram showing an embodiment of the present invention;
Fig. 21 is a timing chart showing the waveforms generated from various operating components of the circuit shown in Fig. 20, and
Fig. 22 is a graph showing the output characteristics of an IGBT.

DETAILED DESCRIPTION OF THE INVENTION

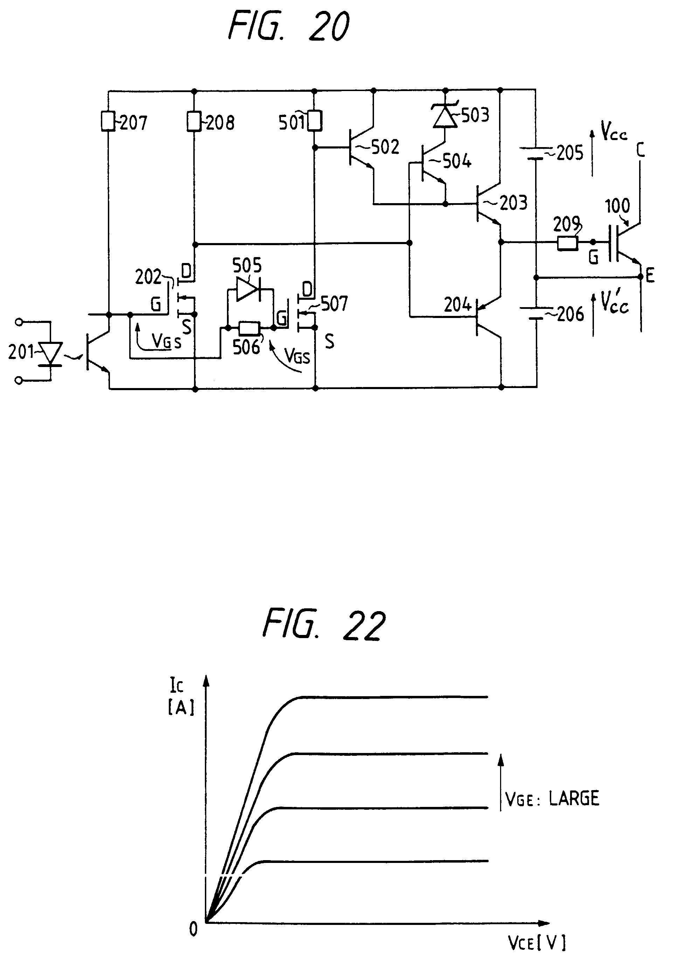

The preferred embodiment of the present invention will be described below with reference to Figs. 20-22.

Fig. 20 shows an embodiment of the present invention, which is a circuit for driving IGBT as a voltage-driven semiconductor device. As in Figs. 6-8, the circuit comprises IGBT 100, photocoupler 201, N channel MOS FET 202, NPN transistor 203, PNP transistor 204, forward bias supply source 205, reverse bias supply source 206, and resistors 207-209.

The drive circuit shown in Fig. 20 further includes a circuit that operates transistor 203 at the output stage as a constant voltage source, and a timer that allows said circuit to work for a predetermined period of time. Stated more specifically, the circuit for operating transistor 203 as a constant voltage source is composed of an NPN transistor 504 the base of which is connected to the base of transistor 204 at the output stage and the emitter of which is connected to the base of transistor 203, a constant voltage diode 503 the anode of which is connected to the collector of NPN transistor 504 and the cathode of which is connected to the positive electrode of forward bias supply source 205, and resistor 208 already mentioned above. The timer is composed of resistor 501 connected between the positive electrode of forward bias supply 205 and the drain of N channel MOS FET 507 which is to be described hereinafter, NPN transistor 502 the collector and base of which are connected to opposite ends of the resistor 501 and the emitter of which is connected to the emitter of transistor 504, FET 507 the drain of which is connected to one end of resistor 501 and the source of which is connected to the negative electrode of reverse bias supply source 206, resistor 506 connected between the gate of FET 507 and the gate of FET 202, and diode 505 connected in parallel to resistor 506, with its cathode being directed to the gate of FET 507.

In the circuit shown in Fig. 20, transistor 502 works in such a way that when it turns on, it shorts the series circuit composed of constant voltage diode 503 and transistor 504, whereas the timer works in such a way that FET 202 will turn off at a slightly different time than FET 507 turns off on account of the resistor 506, as well as the gate input capacitance and gate threshold level of FET 507. Diode 505 serves to allow both FETs 202 and 507 to turn on at the same time.

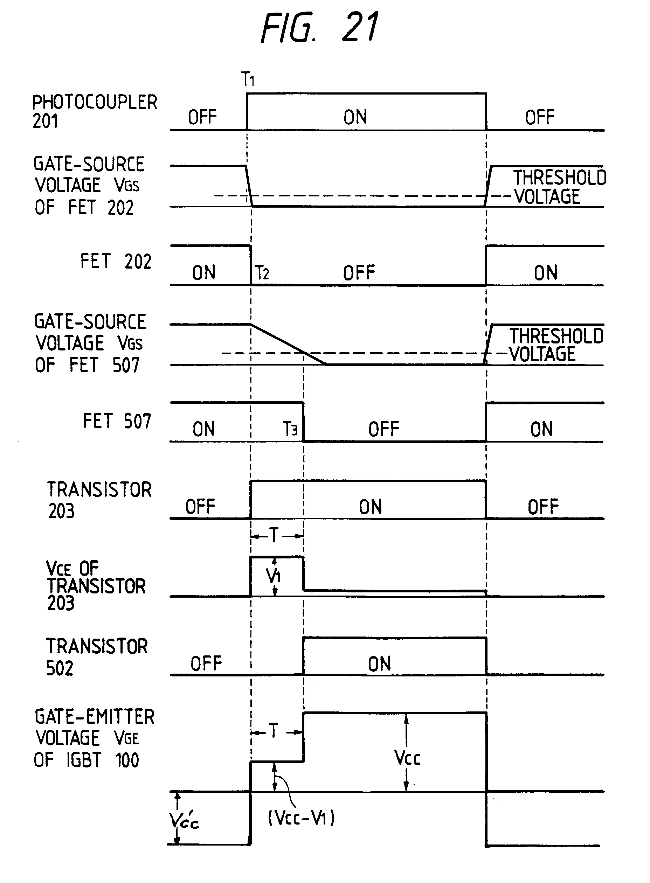

The operation of the circuit shown in Fig. 20 is now described with reference to Fig. 21. When an associated control circuit (not shown) is activated to have a current flow to the primary side of photocoupler 201, thereby turning it on at time $T_1$, FET 202 is first turned off at time $T_2$. When FET 202 turnes off, a current flows to the base of transistor 504 through forward bias supply source 205 and resistor 208, whereupon transistor 504 turns on to have the voltage $V_{ZD}$ of constant voltage diode 503 develop between the collector and base of transistor 203. This voltage permits transistor 203 to function as a constant voltage source and its collector-emitter voltage $V_{CE}$ is equal to:

$$V_{CE} = V_{BE} + V_{ZD} + V_{CE'} \simeq V_{ZD} = V_1 \qquad (3)$$

where $V_{BE}$ is the base-emitter voltage of transistor 203 and $V_{CE'}$ is the collector-emitter voltage of transistor 504. From equation (3), the gate-emitter voltage $V_{GE}$ of IGBT 100 is expressed by:

$$V_{GE} = Vcc - V_1 \simeq Vcc = V_{ZD} \qquad (2)$$

where Vcc is the voltage applied from forward bias supply source 205. In other words, $V_{GE}$ is smaller than Vcc by $V_{ZD}$.

When FET 507 is off, transistor 502 turns on and the circuit composed of constant voltage diode 503 connected in series with transistor 504 is shorted. Therefore, as long as voltage $V_{ZD}$ ($V_1$) is generated, FET 507 remains on as shown in Fig. 21. After photocoupler 201 turns on, the gate-source voltage $V_{GS}$ of FET 507 is discharged via resistor 506 until the value of $V_{GS}$ becomes lower than the threshold level at time $T_3$, when FET 507 turns off. In other words, FET 507 turns off a certain time after FET 202 by the already-described action of the timer. When FET 507 turns off, a base current flows into transistor 502 to turn on. As a result, the circuit composed of constant voltage diode 503 connected in series with transistor 504 is shorted and $V_1$ becomes nearly equal to zero. Thus, the value of $V_{GE}$ is equal to the forward bias voltage Vcc from power supply 205.

According to the embodiment described above, the gate-emitter voltage $V_{GE}$ of IGBT 100 is held at a constant voltage Vcc - $V_1$ lower than the supply voltage Vcc for the period T from time $T_2$ to $T_3$ which is predetermined by the timer. It should also be noted that the period T must be set to be longer than the reverse recovery time of a free-wheeling diode (not shown) connected in series and in opposite direction to IGBT 100 at the output side. Needless to say, voltage Vcc - $V_1$ is higher than the threshold level of IGBT 100.

As described above, the gate emitter voltage $V_{GE}$ of IGBT 100 is held at a comparative low level when it is turned on, and this enables the collector current IC of IGBT 100 to be suppressed at a low level as shown by the IGBT output characteristics curve in Fig. 22. Hence, the reverse recovery current through the free-wheeling diode connected in series to IGBT 100 can be suppressed to reduce the rate of change of current dI/dt, with consequent reduction both in the voltage $V_D$ across the free-wheeling diode and in the rate of change of voltage dV/dt.

Further, as is clear from Fig. 22, the voltage at which IGBT 100 is turned on increases with decreasing voltage $V_{GE}$. However, in the embodiment described above, $V_{GE}$ is held low only for the period T of the time during which IGBT 100 is turned on and in the steady state subsequent ot the lapse of this period T, the voltage for turning on IGBT 100 can be reduced to an adequately low level.

While the foregoing description of the embodiment of the present invention is directed to a circuit for driving IGBT, it should be understood that the concept of the present invention is also applicable to other voltage-driven semiconductor devices such as power MOS FETs.

According to the embodiment of the present invention, when a voltage-driven semiconductor device is turned on, the gate of that semiconductor device is supplied with a comparatively low voltage for a certain period of time predetermined with a timer. As a result, the output current from the semiconductor device is sufficiently suppressed to reduce the reverse recovery current flowing through the free-wheeling diode, thereby preventing the occurrence of overvoltage and reducing the rate of change of voltage. This is effective in preventing not only the destruction of the semiconductor device but also the erroneous operation of the drive circuit and the associated control circuit, thus contributing to an improvement in the device reliability.

In addition, the gate drive circuit of the present invention can be fabricated without requiring any substantial change in the design of prior art circuits but by merely adding a few elements thereto. Thus, it offers the advantage of being fabricated at low cost.

## Claims

1. A gate drive circuit having a voltage-driven semiconductor device (100) and further comprising:

   a free-wheeling diode connected in series with, and in opposite direction to,the output side of said voltage-driven semiconductor device (100);

   a constant voltage circuit (203,205,208,503,504) that upon turning on said semiconductor device (100) supplies the gate of same with a voltage that is higher than a threshold voltage of said semiconductor device (100) but which is lower than the voltage applied to said gate in a steady state; and

   a timer (201,501,502,505,506,507) that causes said constant voltage circuit to operate, when said semiconductor device (100) is on, for at least the reverse recovery time of said diode.

## Patentansprüche

1. Gatetreiberschaltung mit einer spannungsgesteuerten Halbleitervorrichtung (100) und weiterhin enthaltend:

   eine Freilaufdiode, die in Reihe mit und entgegengesetzt gepolt zur Ausgangsseite der spannungsgesteuerten Halbleitervorrichtung (100) geschaltet ist;

   eine Konstantspannungsschaltung (203, 205, 208, 503, 504), die beim Einschalten der Halbleitervorrichtung (100) das Gate derselben mit einer Spannung versorgt, die höher ist als eine Schwellenspannung der Halbleitervorrichtung (100), jedoch niedriger ist als die Spannung, die dem Gate im Gleichförmigkeitszustand zugeführt ist; und

   einen Zeitgeber (201, 501, 502, 505, 506, 507), der bewirkt, daß die Konstantspannungsschaltung arbeitet, wenn die Halbleitervorrichtung (100) eingeschaltet ist, für wenigstens die Rückerholungszeit der Diode.

## Revendications

1. Un circuit d'attaque de grille ayant un dispositif à semiconducteur attaqué en tension (100) et comprenant en outre :

   une diode de roue libre connectée en série, et en direction opposée, au côté de sortie du dispositif à semiconducteur attaqué en tension (100);
   un circuit à tension constante (203, 205, 208, 503, 504) qui, au moment du déblocage du dispositif à semiconducteur (100), applique à la grille de ce dernier une tension qui est supérieure à une tension de seuil du dispositif à semiconducteur (100), mais qui est inférieure à la tension qui est appliquée à cette grille dans un état de régime permanent; et
   un temporisateur (201, 501, 502, 505, 506, 507) qui fait fonctionner le circuit à tension constante, lorsque le dispositif à semiconducteur. (100) est conducteur, au moins pendant le temps de recouvrement inverse de la diode précitée.

FIG. 1(A)   PRIOR ART

FIG. 1(B)   PRIOR ART

FIG. 6   PRIOR ART

FIG. 2 PRIOR ART

## FIG. 3  PRIOR ART

## FIG. 4(A)  PRIOR ART

## FIG. 4(B)  PRIOR ART

$V_{BE} \doteq -I_B \times R_{BE}$

$\therefore R_R << R_{BE}$

# FIG. 5   PRIOR ART

| POWER DEVICE | BIPOLAR TRANSISTOR | IGBT |
|---|---|---|
| DRIVE CURRENT WAVEFORM | 50mA ... -1A, 10μs | 0.8A, LESS THAN 1μs, -0.8A |

EP 0 614 278 B1

## FIG. 7    PRIOR ART

## FIG. 8    PRIOR ART

# FIG. 9 PRIOR ART

# FIG. 10 PRIOR ART

## FIG. 11    PRIOR ART

## FIG. 12    PRIOR ART

## FIG. 13    PRIOR ART

# FIG. 14   PRIOR ART

# FIG. 15

# FIG. 16
## PRIOR ART

# FIG. 18
## PRIOR ART

AT SHORT CIRCUIT

# FIG. 17
## PRIOR ART

# FIG. 19
## PRIOR ART

# FIG. 20

# FIG. 22

## FIG. 21